# EUROPEAN PATENT APPLICATION

(11) **EP 0 654 961 A1**
(43) Date of publication of application: **24.05.1995**
(21) Application number: 94308695.9
(22) Date of filing: 24.11.1994
(51) Int. Cl.: H05K 7/20

(54) **Enhancing electrical insulation between circuit elements**

(71) Applicant: VLT CORPORATION, San Antonio, Texas 78230 (US)
(72) Inventor: Finnemore, Fred M., North Reading, Massachusetts 01864 (US); Vinciarelli, Patrizio, Boston, Massachusetts 02116 (US); Andrus, Lance L., Southboro, Massachusetts 01772 (US)
(74) Representative: Deans, Michael John Percy

(57) **Abstract**

A circuit structure includes spaced apart first and second conductive elements, and a body having two spaced apart points in contact respectively with the first and second conductive elements. An electrically insulating medium is exposed as part of a peripheral outside surface of the body and spans, in the vicinity of the peripheral outside surface, at least a portion of the distance between the first and second conductive elements. An insulating barrier is positioned between the first and second conductive elements and has an aperture through which the body passes. The peripheral outside surface of the body is configured such that the length of the shortest discharge path between the first and second conductive elements is greater than the portion of the shortest distance between the first and second conductive elements which is spanned, in the vicinity of the peripheral outside surface, by the insulating medium.

Also described is a method of forming a window in an insulating barrier. A layer of an insulating material is attached to the conductive layer. The heat sinking conductive layer is positioned in a known position relative to a cutting tool. Cuts are made through the insulating material, at predetermined locations relative to the known position of the conductive layer, to define a window in the insulating material. The insulating material is removed in the region of the window to form the aperture. Both the making of the cuts which define the window, and the removal of the material in the region of the window, may be accomplished by use of a laser.

## Description

This invention relates to enhancing electrical insulation between circuit elements.

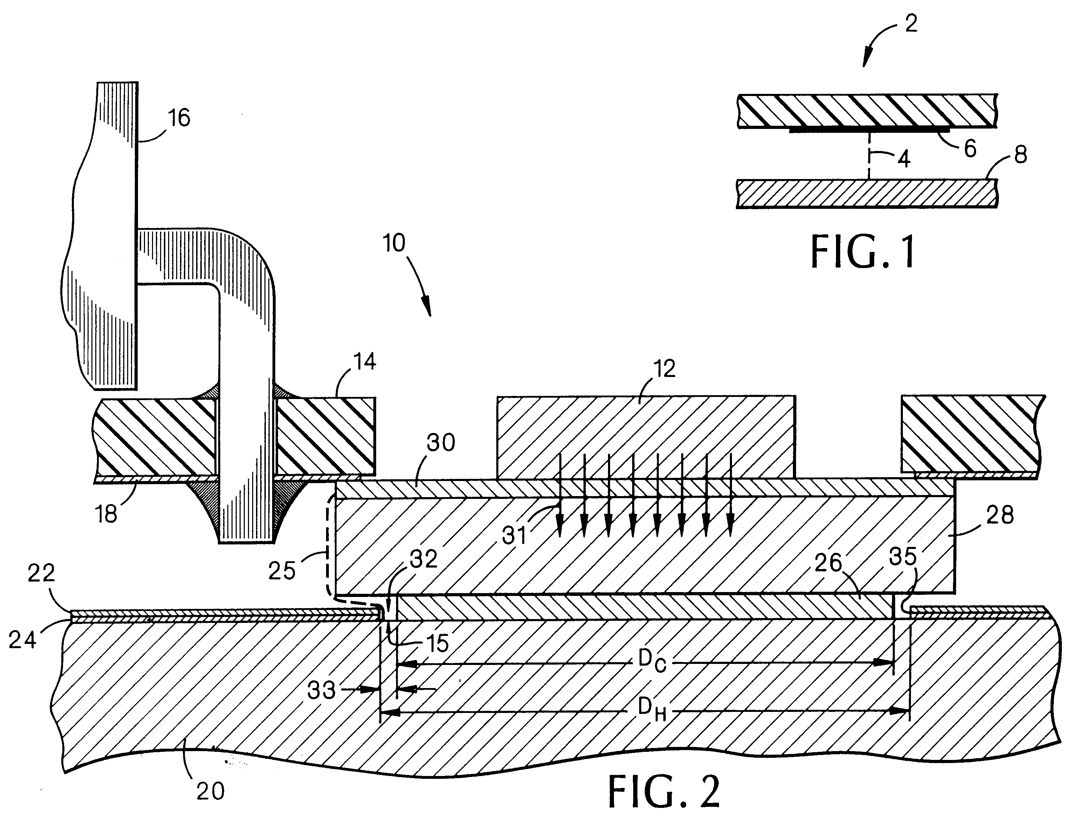

A common issue (for safety and other reasons) in designing and building circuits is ensuring adequate electrical insulation between circuit elements. In a power conversion circuit to (Figure 1) , for example, it may be important to ensure that the electrical insulative capability along a creep path 4 between a printed circuit run 6 and a metal base plate 8 is high enough to prevent electrical discharge along the path when a high potential appears between elements 6 and 8. The insulative capability is affected by the length of the path (the creep distance) and by what lies in the space between electrically conductive elements 6 and 8.

In general, the invention features, in a first aspect thereof, a circuit structure that includes spaced apart first and second conductive elements, and a body having two spaced apart points in contact respectively with the first and second conductive elements. An electrically insulating medium is exposed as part of a peripheral outside surface of the body and spans, in the vicinity of the peripheral outside surface, at least a portion of the distance between the first and second conductive elements. An insulating barrier is positioned between the first and second conductive elements and has an aperture through which the first component passes. The side surface of the component is configured such that the length of the shortest discharge path between the first and second conductive elements is greater than the portion of the shortest distance between the first and second conductive elements which is spanned, in the vicinity of the side surface, by the insulating medium.

Specific embodiments may include the following features:

At least a portion of the aperture has a smaller footprint than does a corresponding portion of the peripheral outside surface of the insulating medium. In some examples, the side surface has a setback in the vicinity of the second conductive element. In some examples, the side surface comprises a sloped contour.

The body may include a heat generating electronic component and a thermally conductive medium, and the second conductive element may include a heat sinking component. The first conductive element may be a conductive trace on a printed circuit board. The insulative barrier may be a sheet of insulating material. The first and second conductive elements may be planar. The two spaced apart points may be conductive and may lie on parallel planar surfaces of the body. The body may have an insulative shelf mounted on and overhanging a conductive pedestal. The printed circuit board may have an aperture for receiving a portion of the body.

In general, in another aspect, the invention features a method of forming an aperture in an insulating barrier. A sheet of insulating material is provided. A layer of the insulating material is attached to the conductive layer. The heat sinking conductive layer is positioned in a known position relative to a cutting tool. Cuts are made through the insulating material, at predetermined locations relative to the known position of the conductive layer, to define a window in the insulating material. The insulating material is removed in the region of the window to form the aperture.

Specific embodiments of the method may include the following features:

The cutting tool comprises a laser. The heat sinking conductive layer is moved to a fixed position relative to the cutting tool and the cutting tool is moved relative to the conductive layer. A beam delivered by the laser is moved along a predetermined path which defines the outline of the window on the surface of the insulating material. A tool (e.g., a razor knife) is used to lift the window. In other examples, the window is removed by heating a region of the window in a manner to render it unattached to the conductive layer. The step of attaching may include heating the conductive layer and the insulating layer while they are being pressed together. Portions of the layer may be attached selectively to the conductive layer by the steps of heating the conductive layer, and pressing together the conductive layer and the insulating layer only in selected regions. A laser beam may be used to render the window unattached to the conductive layer.

Unattached insulating material may be air blown off the surface of the conductive material. A suction device may be used to gather the unattached insulating material. The insulating material may be post-bonded to the conductive layer by heating following the step of removing. The surface of the conductive layer at the window may be cleaned by laser scanning, after the step of removing. A small window may be precut in the layer of insulating material before the step of attaching.

In general, in another aspect, the invention features a method of forming windows in insulating barriers attached to conductive layers moving on a production line and in which the configuration of the window in each of the insulating layers on the production line may be any selected one of a set of configurations. For each of the insulating barriers attached to one of the conductive layers on the production line the following steps are taken. The conductive layer is positioned in a known position relative to a cutting tool. The insulating material is cut, at predetermined locations relative to the known position of the conductive layer, to define the window in the insulating material in accordance with the selected configuration. The insulating material is removed to form the window.

In preferred examples of our circuit structures, the length of the discharge path is increased, while heat is effectively conducted to a heat sinking layer. The windows are cut in a simple, accurate, and rapid fashion. The tolerance range for the positions of the edges of the windows is improved. High mix mode manufacturing of circuits using different window configurations is made possible.

The invention is hereinafter more particularly described by way of example only with reference to the accompanying drawings, in which:-
Fig. 1 is a schematic sectional side view of a portion of a power conversion circuit;
Figs. 2, 2A, 2B, 2C, and 2D are sectional side views of portions of power conversion circuits with enhanced creep distance; and
Figs. 3-8 are cut-away perspective views showing steps in assembly of a power converter circuit.

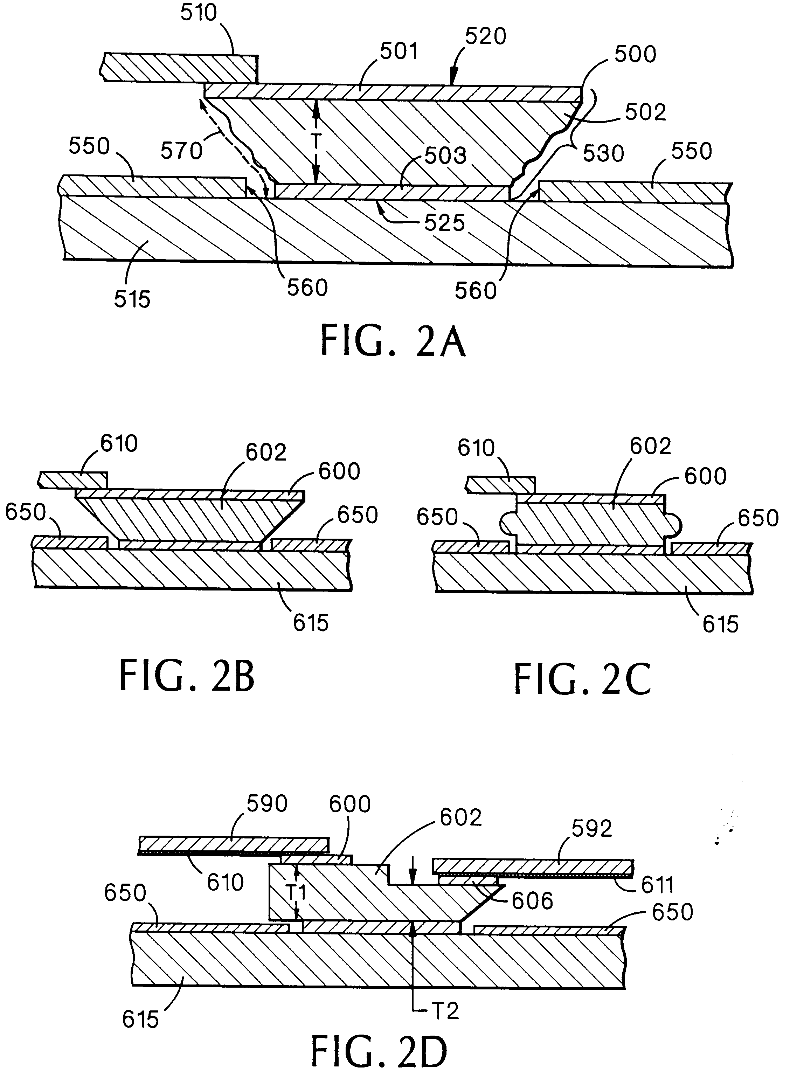

In one possible structural configuration for a power converter 10 (Figure 2), it may be important to increase the creep distance (defined below) along a creep path 25 between a copper trace 18 on the bottom of a printed circuit board (PCB) 14 and the upper surface 15 of an aluminum baseplate 20. By "creep distance" we mean, for example, the length of the shortest path connecting any two conductive points of opposite electrical polarity within a circuit, which path does not pass through a region comprising a suitable insulating medium. Although much of surface 15 is masked by two insulating polymer liners 22, 24, the two liners have a hole 32 to permit mounting of a copper column 26 directly to the aluminum baseplate. A key role of the copper column is to conduct, to the baseplate, heat 31 that originates in a heat dissipating semiconductor die 12. Die 12 is part of the power conversion circuit which is formed on the PCB and includes components 16 mounted in the usual way. Circuit connections from die 12 to traces 18 on the bottom of the PCB are made via a copper conducting layer 30. A ceramic insulating shelf 28 between copper column 26 and copper layer 30 supports the die and the connections to the PCB, conducts heat to the copper column, and, being an electrical insulator, diverts (and increases the creep distance) of path 25. (Some aspects of this configuration are similar to a configuration disclosed in our PCT Application US93/06685 (Publication No: WO94/03038) to which further reference may be made.

The configurations of the copper column, the ceramic pedestal, and the hole in the polymer insulating liners, are chosen with several theoretically conflicting considerations in mind. To maximize the conduction of heat to the baseplate, the copper column should be as nearly as broad as the ceramic shelf as possible. The holes 32 in the two polymer insulating liners should leave as small a gap 33 as possible around the perimeter of the base of the copper column. The creep distance should be maximized by distorting the creep path from what would otherwise be a straight line. The ceramic shelf should not be any larger than necessary as this will reduce the amount of space on the surfaces of the PCB through which component leads (e.g. the lead of component 16) can pass. The ceramic substrate should not be unnecessarily thick as that would increase the thermal resistance between the die and the baseplate, and waste vertical space.

One approach to compromising these otherwise conflicting considerations is illustrated in Figure 2A. A component 500 includes an electrically insulating (e.g., ceramic) layer 502 of thickness T; and two electrically conductive layers 501, 503. Component 500 has a top surface 520, a bottom surface 525, and an outer edge 530. By outer edge we mean the peripheral outside surfaces around the outside of the component defined by the exposed outer peripheral surfaces of the layers which make up the component. Layers 501, 503 could be insulating layers, and the component could also include other layers, not shown.

The top surface 520 is in contact with a first conductive element 510; the bottom surface 525 is in contact with a second conductive element 515. The component 500 passes through an aperture in an insulating barrier 550 which is interposed between the first and second conductive elements. The inner edge of the aperture (e.g., edges 560) are in close proximity to the outer periphery of the bottom surface 525 of the component 500.

The component and the insulating barrier are arranged so that the length of any discharge path (e.g., path 570) between the first and second conductive elements 501, 515 is longer than the path which would otherwise be defined by the thickness, T, of the layer 502 of insulating material alone. In Figure 2A this is accomplished by (1) making the footprint of the bottom surface 525 smaller than the footprint of the top surface and arranging the surfaces so that the outer edge 530 of the component slopes inward, and (2) making the aperture in the insulating layer smaller than the footprint of the top surface 520 and bringing the edge 560 of the insulating layer 550 in close proximity to the outer periphery of the bottom surface 525. By footprint we mean either the region enclosed by an edge along which an object makes contact with another object, or a perpendicular projection of the broadest portions of the periphery of an object on another object.

There are a wide variety of possible configurations that embody the concept suggested by Figure 2A. In Figure 2, a rectangular ceramic shelf sits on a rectangular copper column. The ceramic shelf is broader than hole 32. The copper column is somewhat narrower than the shelf, and hole 32 is somewhat narrower than the ceramic shelf but larger than the size of the copper column.

In Figures 2B and 2C, the combination of the shape of the outer edge of the insulating portion 602 of the component 600 and the arrangement of the aperture in the insulating layer 650 relative to the component produce a discharge path which is longer than the thickness of the insulating material 602 alone.

The components may also be of non-uniform thickness provided that the configuration of the outer edge of the insulating portion of the component and the configuration of the aperture in the insulating layer result in a discharge path which is longer than the thickness of the insulating member in the regions along the periphery of the component where a discharge may occur. In these cases the "thickness" of the insulating member may be interpreted as meaning the thickness of the member at a particular point of interest around the periphery. For example, in Figure 2D, conductive traces 600, 606 lie on two non-coplanar surfaces of an insulating member 602. Conductive etches 610, 611, which form parts of boards 590, 592, respectively, are connected to the traces 600, 606. The insulating member has a thickness of value T1 in the region of the connection of etch 610 to trace 600 and has a smaller value of thickness, T2, in the region of the connection of etch 611 to trace 606. As shown in the Figure, the shapes of the edges of the insulating member 602 in the two regions and the arrangement of the aperture in the insulating layer have been arranged to provide a creep distance in each region which is greater than the thickness of the insulating member in the particular region. Such an arrangement may also be applied to combinations of components and conductors which vary in other ways (e.g., which have non-planar surfaces).

A further consideration in producing large numbers of circuits on an assembly line is the relatively wide tolerances that characterize certain steps in the manufacturing process.

Suppose the sequence of assembly steps is the following, for the embodiment shown in Figure 2: insulating liners 22, 24 are die cut to form holes 32; liners 22, 24 are then bonded to the surface of the baseplate; then die/shelf/column assemblies are mounted in the holes 32. Because the bonding of the liners to the baseplate is imprecise, there is a relatively wide variation in the horizontal positions of the edges 35 of holes 32 relative to the baseplates among different circuits on the assembly line. In order to be sure that the edge of the copper column will always clear edge 35 despite the variation, hole 32 must be die cut with a relatively large breadth DH; or copper column must be given a relatively narrow width DC.

By altering the assembly steps it is possible to permit a relatively narrower hole 32 or a relatively broader copper column 26 (or a combination of the two), while assuring that all circuits will have an adequate clearance 33 and an acceptably large creep distance (e.g., 0.05 inches - 0.127cm). In particular, the polymer insulating liners are first mounted on the baseplate and then the holes are laser cut. By careful control of this process the tolerance ranges of the clearances 33 may be reduced.

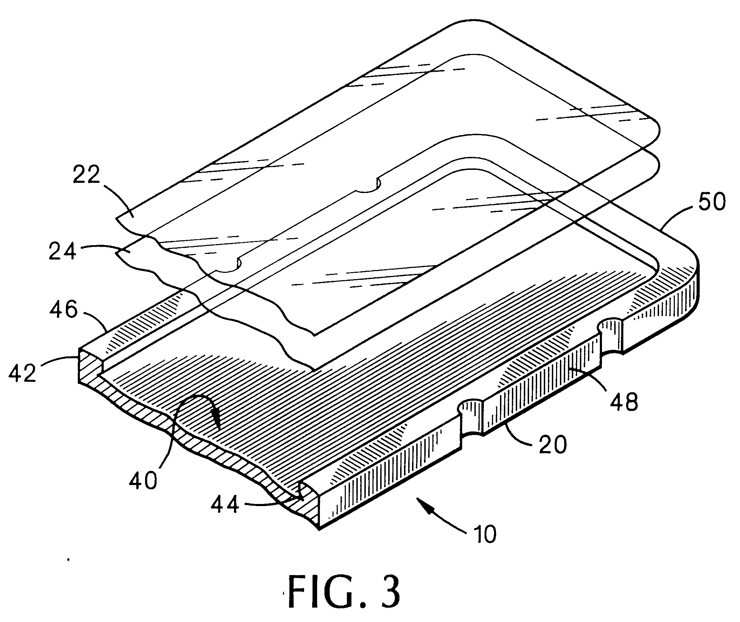

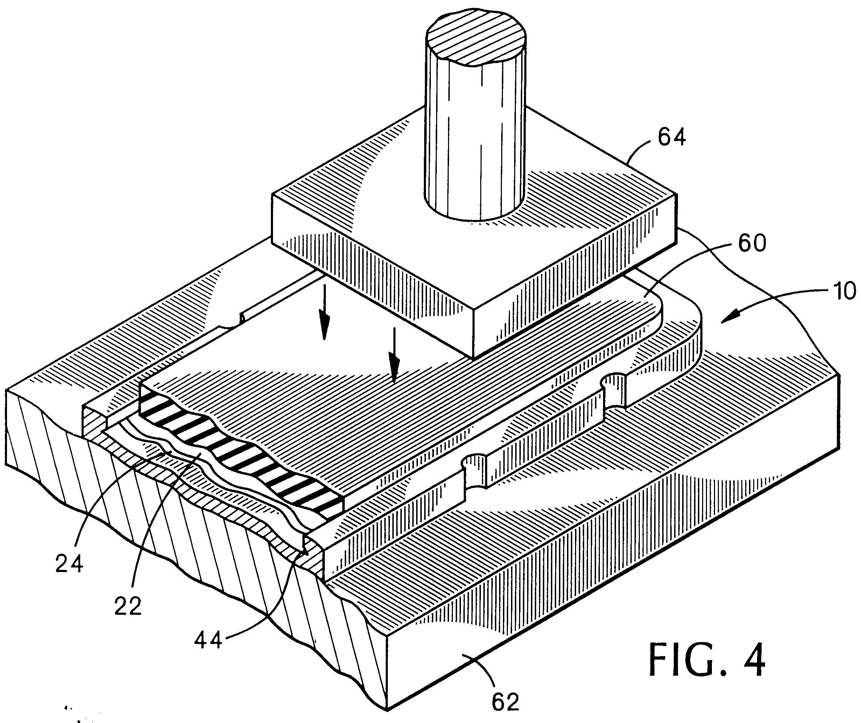

Referring to Figure 3, such a process begins with an aluminium baseplate 20 having a recess 40 and a ridge 42 around its perimeter. The baseplate is approximately 4 inches (10.16cm) long and 2 inches (5.08cm) wide, with a height, in the region of the ridge, of 0.1 inches (0.254cm). The ridge has an undercut 44 along its sides 46, 48, but not along its ends 50. Two Ultem insulating liners 22, 24, available from General Electric Corporation, each with a thickness of 0.001 inches (0.00254cm), are sized to fit on the recess of the baseplate. The length of each liner closely matches the length of the recess; the width of each liner is oversized so that each liner fits snugly within the undercut 44, as shown in Figure 4.

After the two liners are positioned on the recess of the baseplate, a rubber pad 60 is placed on top of the liners, and the baseplate is clamped onto a platen 62. The platen is heated to a temperature of 455 ± 10 degrees Fahrenheit (235 ± 5.5°C) for 15 seconds. This allows the two liners to bond together tightly, while the lower layer 24 tacks to the recessed surface of the baseplate. Clamp 64 applies 500 pounds of force (2224N) on the rubber pad which distributes it evenly over the liners, smoothing them and forcing them to bond together.

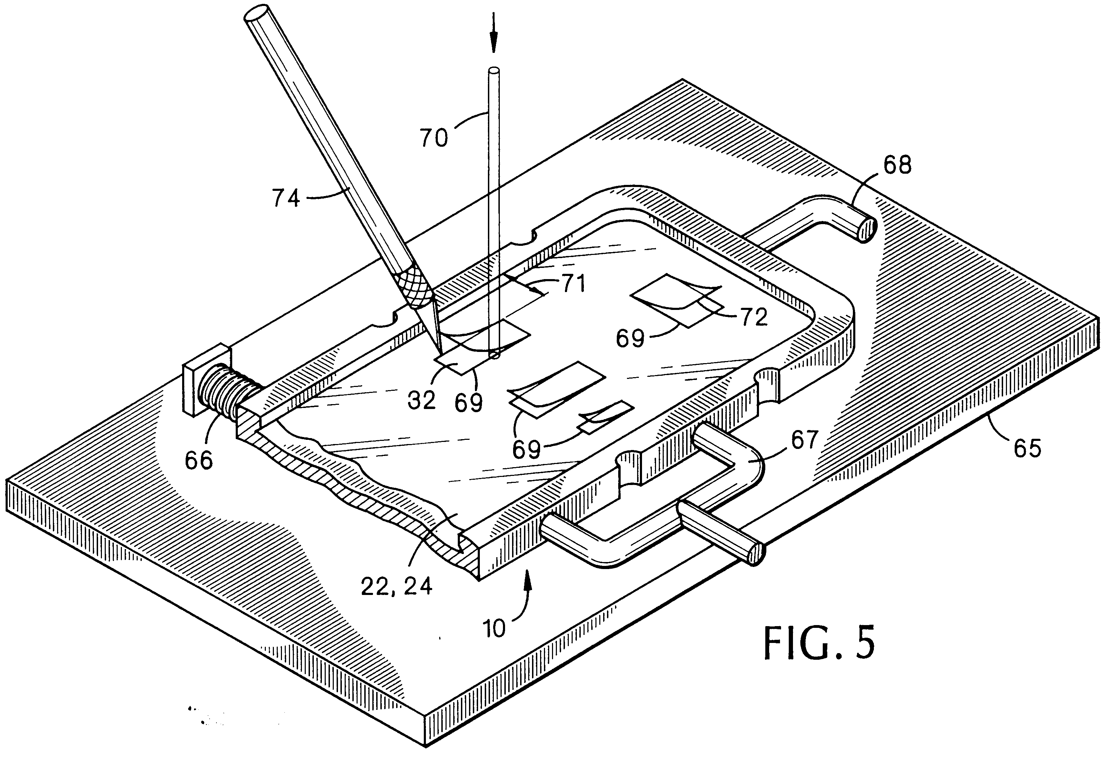

The baseplate with the bonded Ultem liners is then placed on an X-Y table 65 against a spring 66, shown in Figure 5. A positioning device locates three points (not shown) on the bottom of the baseplate to define a plane, two points located by an arm 67 along the length of the baseplate to define an edge, and one point located by an arm 68 in the middle of a short edge of the baseplate. In this way, the positioning device "knows" the precise position and orientation of the baseplate.

The outlines of four windows 69 are laser scribed by a 1064 nm Nd:YAG laser 70 (a Class 1 laser, model number LBI-6000, manufactured by AB Laser, Acton, Massachusetts, USA). First the X-Y table is used to locate the approximate center of one of the four windows under the laser (i.e., the baseplate is moved to a location at which the laser beam would be perpendicular to the surface of the liners 22, 24 at the approximate center of the window). The beam is then directed to move along a path appropriate for cutting the outline of the window. Centering the beam 70 over the window minimizes beam ovaling and angular error. The outline of each window is scanned three times with the laser operating at a pulse rate of 5000 cycles per second, at a speed of 999 mm-per-second, and at a power level of 22 Amperes. This is repeated for each window. More scans at lower power would produce a finer cut at a slower rate.

The scribed windows 72 are peeled away (Figure 5) and then lifted off the baseplate and removed by hand with a razor knife 71, leaving behind the holes 32 in the bonded Ultem liners 22, 24. Alternatively, bubbles may be thermally formed in the Ultem liners, just inside the outline of each window, by using a rubber pad during the tack bonding process from which material has been removed in those regions of the pad which overlay the locations of the windows on the baseplate. In those areas where the rubber material is removed, the liner will not bond to the baseplate and a bubble will form. After laser-cutting the window outline, as described above, the window material may be removed by means of a vacuum process. The latter technique is primarily of use where only a small number of hole configurations are to be cut, as a special rubber pad is needed ror each different hole pattern.

After the windows have been removed, the baseplate is returned to the heated platen 52 for post-bonding at a temperature of 540 ± 10°F (282 ± 5.5°C) for 15 seconds. The post-bonding fully bonds the laser cut Ultem liners to one another and to the baseplate.

The laser cutting of the holes 32 is accurate to within ± 0.005 in (± 0.0127cm) from the edges of the holes to the inner edges of the ridges of the baseplate. This is a significant improvement over the ± 0.025 in (0.0635cm) tolerance if the liners are die cut and then bonded to the baseplate (e.g., the tolerance of dimension 71 in Figure 5). Reduction in this tolerance reduces the variation in the horizontal position of the edges 35 of the holes 32 relative to the edge of the baseplate thereby allowing the size of the copper layer 26 to be made larger relative to the size of the substrate 28 while maintaining some minimum desired creep distance 25 (e.g. .050 inch - 0.127cm) from the copper trace 18 to the aluminium baseplate 20.

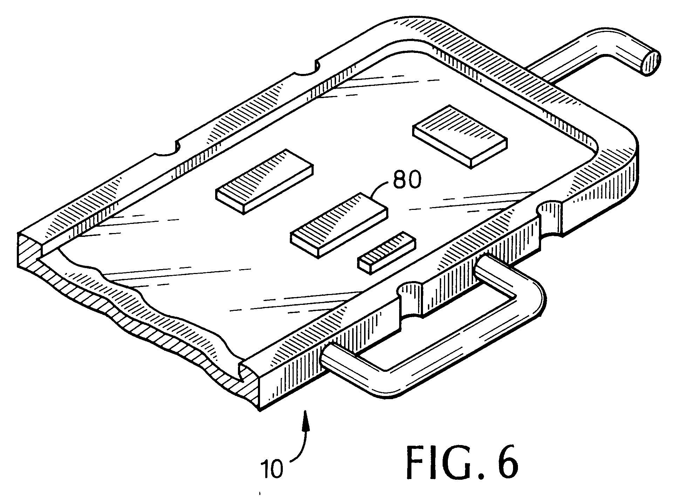

After the Ultem liners are laser cut, die/shelf/column assemblies 80 are placed in the windows, as shown in Figure 6. Finally, the PCB board is mounted over the assemblies and the copper traces 18 are connected to the copper conducting layer(s). The final structure is shown in detail in Figure 2. In one example, copper column 26 is 0.005 in. (0.0127cm) thick and ceramic substrate 28 is 0.020 in. (0.0508cm) thick.

In another method of assembly, the Ultem liners 22, 24 are first firmly bonded to the baseplate in one heating step (Figure 4), by heating platen 62 to 540°F (282°C) for 9 seconds. Clamp 64 applies 500 pounds of force (2224N) to rubber pad 60 during heating. The baseplate with the bonded Ultem liners is then mounted on X-Y table 65 (Figure 5).

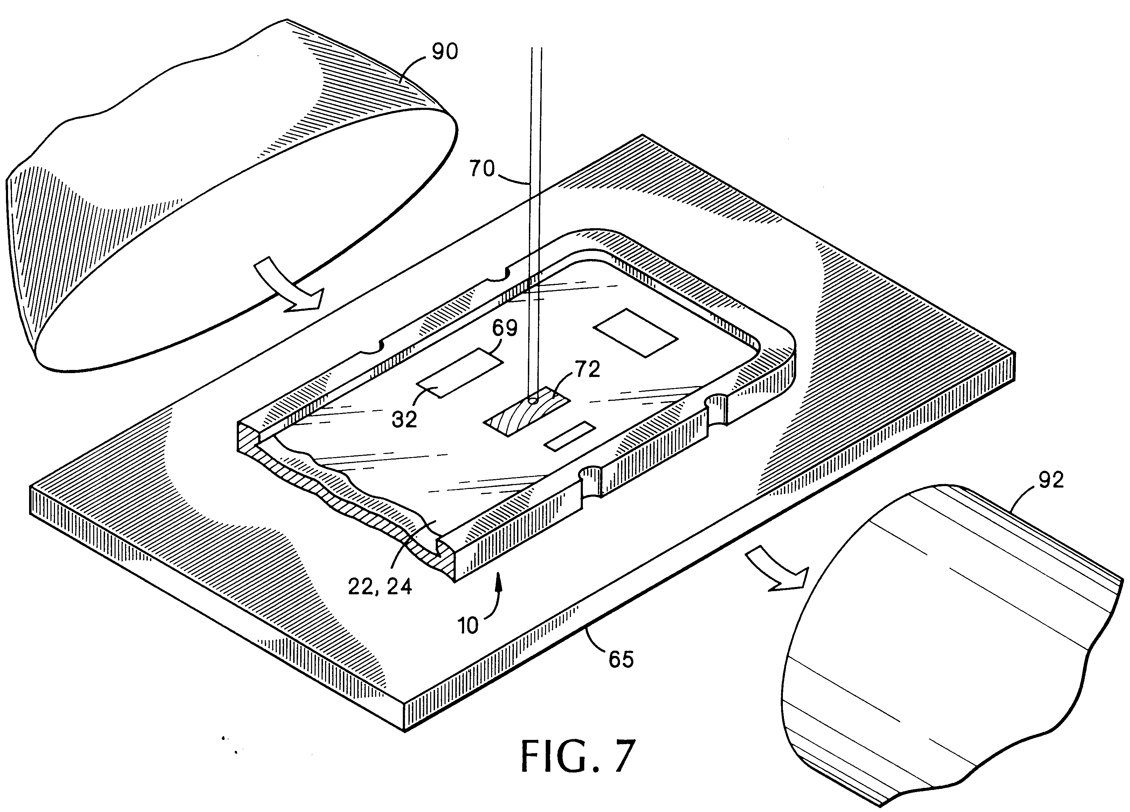

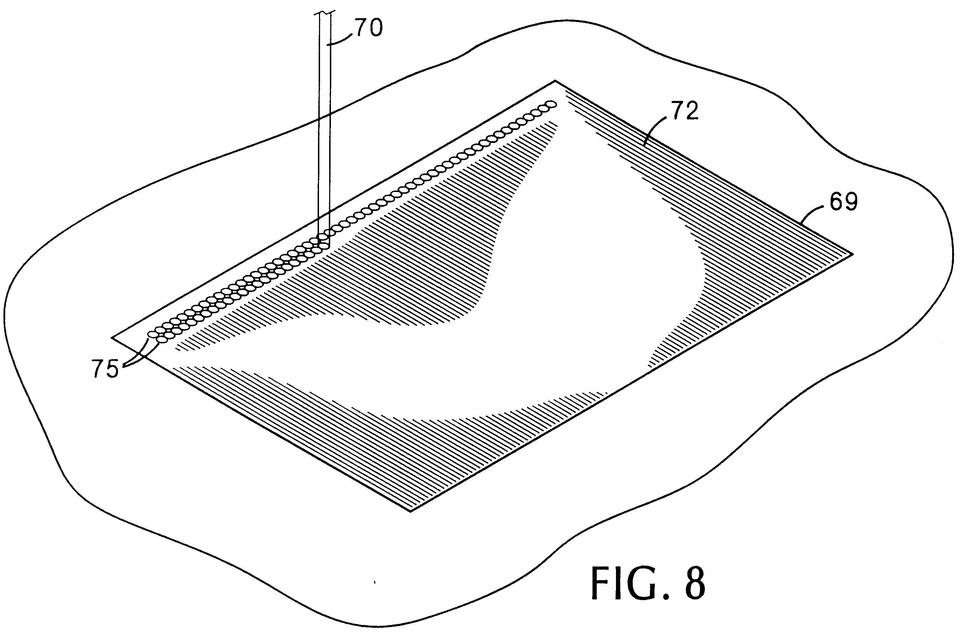

Referring now to Figures 7 and 8, windows 72 in the Ultem liners are delaminated from the baseplate by scanning the area within the window with the beam from the Nd:YAG laser 70 in a pattern of parallel, linear, scans 75, each of which runs the length of the window. The laser is operated at a pulse rate of 2500 cycles per second, at a speed of 999 mm/second and at a power level of 20 to 22 Amperes. The beam diameter is nominally 0.00475 inches (0.012065cm). As each linear scan is completed the centre of the beam is offset by 0.005 inch (0.0127cm) and another linear scan is performed along a line parallel to the first. This process is continued until the entire window area has been scanned. The effect of the scanning is to heat the Ultem liners within the window region to a temperature which exceeds the bonding temperature, thereby causing the windows to lift off the baseplate, as shown.

The laser next scans the outline 69 of the windows at a pulse rate of 2500 cycles per second, at 100 mm/s, at the same power as the first scan. This second scan detaches the material within the windows from the remainder of the Ultem liners.

Air is now blown onto the Ultem liners from airjet 90, and vacuum 92 applies suction to pull the windows off the baseplate, leaving behind holes 32.

The laser then scans the exposed surface of the baseplate within the holes to clean the surface of any carbonized Ultem (Ultem "dust") or aluminum particles produced by the first scan. The laser once again covers the entire area of the hole using a pattern of parallel linear scans. The laser is operated at a pulse rate of 20,000 cycles per second, at a power level of 20 to 22 amps and at a speed of 999 mm/second. The nominal laser beam diameter is 0.00475 inch (0.012065cm) and the centre-to-centre distance between parallel scan lines is 0.003 inches - (0.00762cm). This "cleaning" operation produces an essentially contaminant-free surface finish on the aluminium baseplate, etched to a depth of approximately 100 microinches (0.000254cm). This, in turn, provides a nearly optimum surface for producing high quality adhesive bonds between the copper column 18 (Figure 2) and the surface of the baseplate.

The method outlined above produces an excellent surface finish at a high speed of production (a typical window pattern is cut in 19 seconds). To produce an even smoother surface finish, an excimer (excited dimer) laser could be used to completely vaporize the Ultem within the windows. A CO₂ laser also provides a smoother finish, but scans more slowly than an ND:YAG laser.

The method outlined above is high speed, because the windows are removed automatically and the Ultem liners are bonded to the baseplate in only one step. To increase speed even further, the initial scan can be performed at a power lower than 20 amps, to reduce the amount of Ultem dust left behind in the holes, so that no third scan is needed. Alternatively, small windows can be pre-cut in the insulating liners before they are bonded to the baseplate, e.g. 75% of the area of the windows are pre-cut. The first laser scan then delaminates only the remaining 25% of the windows.

The laser can also be used to burn off the windows, instead of delaminating them, by first scanning the windows at a higher power for a longer time.

Laser cutting allows any combination of hole patterns to be cut into liners after they have been bonded to a baseplate. In a high volume, high mix automated production environment, in which a wide variety of products, each possibly having different combinations of die/shelf/column assemblies mounted in differing configurations on a variety of different sized baseplates, a single laser hole cutting apparatus may be used to produce an essentially infinite variety of hole patterns in the insulating liners of the various sizes of baseplate assemblies. This avoids the need for stocking and handling many different kinds of preassembled baseplates having precut hole patterns and allows production of any needed baseplate on a "lot-of-one" basis.

Other embodiments are feasible. For example, the die/shelf/column assembly may be fabricated from a variety of materials other than copper and ceramic.

## Claims

1. A circuit structure comprising: spaced apart first and second conductive elements; a body having two spaced apart points in contact respectively with said first and second conductive elements, and an electrically insulating medium exposed as part of a peripheral outside surface of said body and spanning, in the vicinity of said peripheral outside surface, at least a portion of the distance between said first and second conductive elements; and an insulating barrier having an aperture through which said body passes, said insulating barrier being positioned between said first and second conductive elements; said peripheral outside surface of said body and said insulating barrier being configured such that the length of the shortest discharge path between said first and second conductive elements is greater than the portion of the shortest distance between said first and second conductive elements which is spanned, in the vicinity of said peripheral outside surface, by said insulating medium.

2. The structure of Claim 1, wherein at least a portion of said aperture has a smaller footprint than does a corresponding portion of the peripheral outside surface of said insulating medium.

3. The structure of Claim 1, wherein said peripheral outside surface comprises a setback in the vicinity of the second conductive element.

4. The structure of Claim 1, wherein said peripheral outside surface comprises a sloped contour.

5. The structure of Claim 1, wherein said second conductive element comprises a heat sinking component, and said body comprises a thermally conductive medium.

6. The structure of Claim 5, wherein said body comprises a heat generating component, preferably a heat generating electronic component.

7. The structure of Claim 1, wherein said first conductive element comprises a conductive trace on a printed circuit board.

8. The structure of Claim 1, wherein said insulative barrier comprises a sheet of electrically insulating material.

9. The structure of Claim 1, wherein one or both of said first and second conductive element is(are) planar.

10. The structure of Claim 1, wherein said two spaced apart points lie on parallel planar surfaces of said body.

11. The structure of Claim 1, wherein said two spaced apart points are conductive.

12. The structure of Claim 1, wherein said body comprises an insulative shelf mounted on and overhanging a conductive pedestal.

13. The structure of Claim 1, wherein said first conductive element is on a printed circuit board and said printed circuit board has an aperture for receiving a portion of said body.

14. A method for enhancing electrical insulation between spaced apart first and second conductive elements along a body which has two spaced apart points in contact respectively with said first and second conductive elements, and an electrically insulating medium exposed as part of a peripheral outside surface of said body and spanning, in the vicinity of said peripheral outside surface, at least a portion of the distance between said first and second conductive elements; the method comprising the steps of: positioning an insulating barrier between said first and second conductive elements, said insulating barrier having an aperture through which said body passes, and configuring said peripheral outside surface of said body and said insulating barrier such that the length of the shortest discharge path between said first and second conductive elements is greater than the portion of the shortest distance between said first and second conductive elements which is spanned, in the vicinity of said peripheral outside surface, by said insulating medium.

15. A method of forming an insulating barrier having an aperture, on a surface of a conductive layer, comprising the steps of: providing a supply of sheet insulating material; attaching a layer of said insulating material to said conductive layer; positioning said conductive layer in a known position relative to a cutting tool; cutting through said insulating material, at predetermined locations relative to said known position of said conductive layer, to define a window in said insulating material; and removing said insulating material in the region of said window to form said aperture.

16. A method of forming windows in insulating barriers attached to conductive layers moving on a production line and in which the configuration of the window in each of said insulating layers on said production line may be any selected one of a set of configurations, comprising, for each of said insulating barriers attached to one of said conductive layers on said production line, the steps of: positioning said conductive layer in a known position relative to a cutting tool; cutting through said insulating material, at predetermined locations relative to said known position of said conductive layer, to define said window in said insulating material in accordance with said selected configuration; and removing said insulating material to form said window.

17. A method according to Claims 3, 15 or 16, wherein said cutting tool comprises a laser.

18. A method according to Claim 17, wherein said positioning step comprises locating said conductive layer at a position at which a beam of said laser is perpendicular to a surface of said layer of insulating material at a point which is at the approximate centre of said window.

19. A method according to Claim 17, wherein said cutting step comprises moving a beam of said laser along a predetermined path which defines the outline of said window on the surface of said insulating material.

20. A method according to any of Claims 15 to 19, wherein said removing step comprises using a tool to lift said window off said conductive material.

21. A method according to Claim 20, wherein said tool comprises a razor knife.

22. A method according to any of Claims 15 to 21, wherein said removing step comprises heating a region of said window in a manner to render it unattached to said conductive layer.

23. A method according to Claim 22, wherein said heating step comprises scanning the region within the window with a laser beam.

24. A method according to any of Claims 15 to 23, wherein said attaching step comprises heating said conductive layer and said layer while they are being pressed together.

25. A method according to Claim 24, wherein said attaching step further comprises selectively attaching portions of said layer to said conductive layer by the steps of heating said conductive layer, and pressing together said conductive layer and said layer only in selected regions.

26. A method according to Claim 22, wherein said conductive layer heating step comprises heating at least a portion of said window using a laser beam to render said window unattached to said conductive layer.

27. A method according to Claim 22 or any claims appendant thereto, further comprising air blowing said unattached insulating material off the surface of said conductive material.

28. A method according to Claim 27, further comprising using a suction device to gather said unattached insulating material.

29. A method according to any of Claims 15 to 28, further comprising post-bonding said insulating material to said conductive layer by heating following said removing step.

30. A method according to any of Claims 15 to 29, further comprising cleaning the surface of the conductive layer at the window by laser scanning, after the removing step.

31. A method according to any of Claims 15 to 30, further comprising precutting a small window in the layer of insulating material before the step of attaching.

32. Apparatus for forming an insulating barrier having an aperture, on a surface of a conductive layer comprising: a supply of sheet insulating material; a bonder adapted for operatively attaching a layer of said insulating material to said conductive layer; a stage adapted for positioning said conductive layer in a known position relative to a cutting tool; a cutter configured operatively to cut through said insulating material, at predetermined locations relative to said known position of said conductive layer, to define a window in said insulating material; and a remover adapted for operatively removing said insulating material in the region of said window to form said aperture.
